(19)

Europäisches
Patentamt

European
Patent Office

Office européen
des brevets

(11) **EP 4 664 162 A1**

(12) **EUROPEAN PATENT APPLICATION**

(43) Date of publication:
**17.12.2025 Bulletin 2025/51**

(21) Application number: **24201320.9**

(22) Date of filing: **19.09.2024**

(51) International Patent Classification (IPC):
**G01W 1/10** (2006.01)     **G06N 3/042** (2023.01)

(52) Cooperative Patent Classification (CPC):
**G01W 1/10; G06N 3/042; G06N 3/045**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.06.2024 CN 202410756318**

(71) Applicant: **State Power Rixin Tech. Co., LTD.
Beijing 100096 (CN)**

(72) Inventors:
• **XIANG, Jie
  Beijing, 100096 (CN)**
• **YONG, Zheng
  Beijing, 100096 (CN)**
• **CHEN, Jianqiang
  Beijing, 100096 (CN)**
• **CHEN, Longjing
  Beijing, 100096 (CN)**
• **XU, Yu
  Beijing, 100096 (CN)**

(74) Representative: **Michalski Hüttermann & Partner
Patentanwälte mbB
Kaistraße 16A
40221 Düsseldorf (DE)**

(54) **METHOD AND APPARATUS FOR CONSTRUCTING NEW-ENERGY METEOROLOGICAL LARGE MODEL, AND POWER PREDICTING METHOD**

(57) A method and apparatus for constructing a new-energy meteorological large model, and a power predicting method are provided by the present application. The method includes, based on ERAS data, constructing datasets for training the new-energy meteorological large model; constructing a graph-neural-network large model that has a wind-solar node attention mechanism and a dynamic graph structure; applying the constructed input dataset and output dataset into the graph-neural-network large model, and performing training on the graph-neural-network large model to obtain the new-energy meteorological large model; and by using the new-energy meteorological large model, obtaining new-energy meteorological-element-prediction data, and inputting the station new-energy meteorological-prediction data into the meteorology-power post-correction model to obtain a predicted power. In the present application, the accuracy of prediction on wind-solar meteorological variables by meteorological large models is increased, and it is of great significance for the improvement of the power prediction service.

FIG. 1

# EP 4 664 162 A1

## Description

TECHNICAL FIELD

The present application relates to the technical field of new-energy electric power and, more particularly, to a method and apparatus for constructing a new-energy meteorological large model, and a power predicting method.

BACKGROUND

In the field of new energy, the wind-solar power prediction has been relying on numerical weather prediction (NWP) as its main meteorological basis. However, the traditional NWP models require a large amount of computational resource and have certain uncertainties due to its physical process containing complex parameters, which leads to a great deal of room for improvement in the timeliness and accuracy of numerical weather prediction data used for new-energy power prediction. In view of this problem, the emergence of meteorological large models provides a disruptive solution. Such purely data-driven large models training on massive historical meteorological data have a computational efficiency significantly higher than the traditional NWP models, and have a higher prediction accuracy.

However, the output results of the existing meteorological large models mainly serve the general meteorological demands, and are not customized or optimized with respect to the particular demands of the new-energy industry, resulting in relatively low accuracy in the prediction on critical new-energy meteorological variables such as the hub-height wind and the irradiance, which makes it difficult to meet the specialized requirements for the new-energy power prediction.

From the perspective of the meteorological techniques on which the power prediction depends, most of the power predicting methods now rely on the meteorological data generated by the NWP models. Constrained by the computational volume and the prediction accuracy of the NWP models, the model updating frequency and the prediction duration are limited, which restricts the further improvement of the wind-solar power prediction. Moreover, the non-customized results for generic meteorological services are not specifically optimized with respect to the hub-height wind and the irradiance, which also limits the ability of the models to predict the critical meteorological variables for wind and solar to a certain extent.

From the perspective of the structure of graph-neural-network meteorological large models, the existing graph neural networks mostly utilize static graph structure in meteorological prediction. However, meteorological conditions and energy-source demands are dynamically changing, and the static graph structure which is unable to associate similar variables beyond those static graphs, cannot further increase the capability of simulating the dynamics meteorology. The introduction of the dynamic graph structure allows the model to adjust the connection mode of the graphs according to the temporal dynamics and the variation in the meteorological conditions, which increases the accuracy of the model. In addition, there have already been graph-neural-network meteorological large models in which the nodes and the edges between the graphs utilize MLP to map and transmit information, the contributions of the neighboring nodes and edges in the graph structure are equal, or are weighted according to inverses of the node degrees. However, the importance of the neighbors in aggregating features from adjacent nodes cannot be dynamically determined, which restricts the models from further improving the ability in predicting the target meteorological variables.

SUMMARY

A method and apparatus for constructing a new-energy meteorological large model, and a power predicting method are provided by the present application, which breaks through the limitation of existing meteorological large models, and increases the accuracy of prediction on new-energy meteorological variables by large models.

In order to achieve the above object, the technical solutions of the present application are implemented as follows:

In a first aspect, a method for constructing a new-energy meteorological large model is provided by the present application, wherein the method includes:

S1: based on ERA5 data, constructing datasets for training the new-energy meteorological large model, wherein an input dataset includes reanalysis data, the reanalysis data refers to the ERA5 data with a longitude-latitude grid resolution being 0.25°×0.25°, an output dataset includes wind-speed data and irradiance data that are interpolated from the ERA5 data to locations of wind and solar power plants, and measured wind-speed data and measured irradiance data;

S2: constructing a graph-neural-network large model that has a wind-solar-node attention mechanism and a dynamic graph structure, wherein the dynamic graph structure is configured to be a multilayer grid-graph structure encircling an exterior of earth, layers represent different pressure levels, and grid points in each of layers represent nodes of the graph-neural network; in a layer closer to ground, the nodes have a higher density, and the nodes and edges have higher quantities; and

the graph-neural-network large model includes an encoder, a processor and a decoder:

the encoder is configured for embedding input data of meteorological variables, i.e., the reanalysis data, into nodes and edges of an initial dynamic graph structure;

the processor is configured for updating the dynamic graph structure by using data in the input dataset and adding the wind-solar-node attention mechanism to process features of the nodes and the edges in the dynamic graph structure; and

the decoder is configured for decoding node features and edge features processed by the processor to be output meteorological-prediction data;

S3: the input and output dataset constructed in step S1 are applied to the graph-neural-network large model in step S2, followed by training the graph-neural-network large model to obtain the new-energy meteorological large model.

In some embodiments of the present application, the encoder in step S2 is specifically configured for:

S211: initializing the dynamic graph structure, so that a quantity of the nodes of each of the layers is in direct proportion to an atmospheric pressure of that layer, neighboring layers are interconnected via the edges, and a quantity of the edges that interconnecting two neighboring layers is in direct proportion to a sum of the atmospheric pressures of the two neighboring layers; and

S212: performing standardization to each of the input data of meteorological variables in the input dataset, and mapping the standardized input data to the nodes and the edges of the dynamic graph structure, so that each of the nodes and each of the edges of the dynamic graph structure carry high-dimension meteorological-feature information.

In some embodiments of the present application, the processor in step S2 is specifically configured for:

S221: based on the dynamic graph structure, calculating a conditional intensity function between the nodes, and determining whether to add the edges or delete the edges between the nodes according to the conditional intensity function; and

S222: applying a linear transformation to feature vectors of each of the nodes, and based on the attention mechanism, calculating attention coefficients between the nodes, normalizing all of the attention coefficients of each of the nodes, and, by using the normalized attention coefficients and the feature vectors after the linear transformation, calculating new feature vectors of the nodes.

In some embodiments of the present application, the decoder in step S2 is specifically configured for: performing inverse mapping to node information and edge information in the dynamic graph structure, and generating one predicted value for each of the nodes, wherein the predicted value is a meteorological-prediction datum of a next moment.

In a second aspect, an apparatus for constructing a new-energy meteorological large model is provided by the present application, wherein the apparatus includes:

a dataset module configured for based on ERA5 data, constructing datasets for training the new-energy meteorological large model, wherein an input dataset includes reanalysis data, the reanalysis data refers to the ERA5 data with a longitude-latitude grid resolution being 0.25°×0.25°, an output dataset includes wind-speed data and irradiance data that are interpolated from the ERA5 data to locations of wind and solar power plants, and measured wind-speed data and measured irradiance data;

a model module configured for constructing a graph-neural-network large model that has a wind-solar-node attention mechanism and a dynamic graph structure, wherein the dynamic graph structure is designed to be a multilayer grid-graph structure encircling an exterior of the earth, layers represent different pressure levels, and grid points in each of the pressure levels represent nodes of the graph-neural-network; in a layer closer to ground, the nodes have a higher density, and the nodes and edges have higher quantities; and

the graph-neural-network large model includes an encoder, a processor and a decoder:

the encoder is configured for encoding and embedding input data of meteorological variables, i.e., the reanalysis data, into nodes and edges of an initial dynamic graph structure;

the processor is configured for updating the dynamic graph structure by using data in the input dataset and adding the wind-solar-node attention mechanism to process features of the nodes and the edges in the dynamic graph structure; and

the decoder is configured for decoding node features and edge features processed by the processor to be output meteorological-prediction data;

a training module configured for applying the input dataset and the output dataset constructed by the dataset module into the graph-neural-network large model constructed in the model module, and performing training on the graph-neural-network large model to obtain the new-energy meteorological large model.

In some embodiments of the present application, the encoder of the model includes:

an initializing unit configured for initializing the dynamic graph structure, so that a quantity of the nodes of each of the layers is in direct proportion to an atmospheric pressure of that layer, neighboring layers are interconnected via the edges, and a quantity of the edges interconnecting two neighboring layers is in direct proportion to a sum of the atmospheric pressures of the two neighboring layers; and
a data embedding unit configured for performing standardization to each of the input data of the meteorological variables in the input dataset, and mapping the standardized input data to the nodes and the edges of the dynamic graph structure, so that each of the nodes and each of the edges of the dynamic graph structure carry high-dimension meteorological-feature information.

In some embodiments of the present application, the processor of the model includes:

an updating unit configured for based on the dynamic graph structure, calculating a conditional intensity function between the nodes, and determining whether to add the edges or delete the edges between the nodes according to the conditional intensity function; and
an attention unit configured for applying a linear transformation to feature vectors of each of the nodes, calculating attention coefficients between the nodes based on the attention mechanism, , normalizing all of the attention coefficients of each of the nodes, and calculating new feature vectors of the nodes using the normalized attention coefficients and the feature vectors after the linear transformation.

In some embodiments of the present application, the decoder in the model is specifically configured for:
performing inverse mapping to node information and edge information in the dynamic graph structure, and generating one predicted value for each of the nodes, wherein the predicted value is a meteorological-prediction data of a next moment.

In a third aspect, a method for predicting a new-energy power is further provided by the present application, wherein the method includes by using historical new-energy wind-solar meteorological-element data and an actually measured power, training to obtain a meteorology-power post-correction model; and by using the new-energy meteorological large model constructed by using the method for constructing a new-energy meteorological large model stated above, obtaining new-energy meteorological-prediction data at locations of wind and solar plants, and inputting the obtained new-energy meteorological-prediction data into the meteorology-power post-correction model to obtain a predicted power.

In a fourth aspect, a device for predicting a new-energy power is further provided by the present application, wherein the device is configured for, by using historical new-energy wind-solar meteorological-element data and an actually measured power, training to obtain a meteorology-power post-correction model; by using the new-energy meteorological large model constructed by using the apparatus for constructing the new-energy meteorological large model stated above, obtaining new-energy meteorological-prediction data at locations of wind and solar power plants, and inputting the obtained new-energy meteorological-prediction data into the meteorology-power post-correction model to obtain a predicted power.

Compared to the related art, the present application has the following advantageous effects:
Firstly, in the present application, the multilayer dynamic graph structure is introduced into meteorological large models based on a graph neural network. The multilayer graph structure approximately simulates the meteorological variables at different heights encircling the earth shell, wherein at the near-earth layers, the grid points are distributed more densely, which improves the capability of the model in predicting the near-earth new-energy meteorological variables. In addition, while most of the existing graph neural networks employ a static graph structure, the meteorological conditions, especially the near-earth-surface new-energy meteorological variables, vary quickly and dynamically. The introduction of the dynamic graph structure allows the model to adjust the connection mode of the graph according to the time-sequence dynamics and the variations of the meteorological conditions, which further increase the accuracy of the model.

Secondly, in the present application, the node attention mechanism is added into graph neural networks. In the existing meteorological large models, degrees of attention paid to different meteorological variables in the models are the same. With the introduction of the node attention, the attention mechanism may automatically evaluate the influences of each meteorological variable on the key new-energy meteorological variables, such as, the hub-height wind and the irradiance, so that the model predicting capability is more focused on the emphasized new-energy meteorological variables, which further increases the accuracy of prediction on the wind-solar meteorological variables by the meteorological large model.

Thirdly, in the present application, the power predicting method based on the new-energy meteorological large model integrates the new-energy-power predicting methods of the leading-edge techniques such as big-data processing, deep learning and machine learning. The methods, based on the technique of new-energy meteorological large models, optimize the prediction on the new-energy-related variables from global meteorological source, thereby breaking through the dependencies of the existing power prediction on the traditional meteorological numerical weather prediction, increasing the efficiency and the accuracy of the meteorological models in service prediction on the important new-energy meteorological variables, such as the wind speed and the irradiance, solving the difficulties of meteorological service in the field of new energy, as well as exceeding many limitations of the traditional NWP, which are of great significance for the improvement of the power prediction service.

BRIEF DESCRIPTION OF THE DRAWINGS

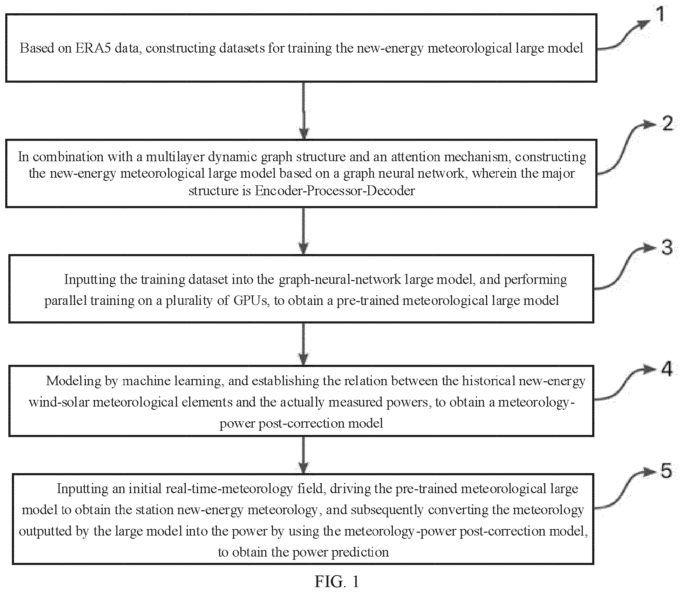

FIG. 1 is a schematic flow chart of an embodiment of the present application.

DETAILED DESCRIPTION

It should be noted that, without conflict, the embodiments of the present application and the features in the embodiments can be combined with one another.

The present application will be further described below with reference to the particular embodiments and the drawings.

Firstly, the terminologies in the present application will be explained:

Graph Neural Network (GNN): a graph neural network is a neural-network architecture that is specially used to process graph-structure data. Graph-structure data is composed of nodes (vertices) and edges and is commonly used in the fields such as social networks, molecular structures and traffic networks. The core of GNN lies in its ability to capture dependencies between nodes and learn the node representations by transmitting information between the nodes of the graph. Such information transmission is usually realized by a message transmission mechanism, and the nodes may update their states according to the features of the neighboring nodes and their own features.

Multilayer Perceptron (MLP): multilayer perceptron is a feedforward artificial neural network. It includes one or more hidden layers, and can learn nonlinear function approximation. MLP is one of the most fundamental models in deep learning, and is suitable for the tasks of predicting output variables from a group of input variables. Each node (usually referred to as "neuron") is connected respectively to all the nodes in the preceding layer, and calculates a weighted sum, which may usually apply a nonlinear activation function. Each layer of the MLP is fully connected, which means that each of the neurons is connected to all the neurons of the preceding layer. MLP is trained by a back propagation algorithm that optimizes the weights to minimize the difference between the prediction and the actual output.

Softmax function: the Softmax function is a function that is widely used in multi-class classification. It converts a vector containing any number of real numbers into a probability distribution of the real-number values, where the probabilities are between 0 and 1 and has a sum of 1. The output of this function may be interpreted as a probability distribution, and the value of each component represents the probability of selecting the corresponding category.

Attention mechanism (Attention): the attention mechanism is a technique in models or algorithms that enables the models to, automatically determine to which part of the data is more important to "pay attention to" when processing the data. The attention mechanism is usually realized by calculating the weighted sum of the inputted features, where the weights are obtained by the model based on data learning and reflect the relative importance of each part. The attention mechanism has been proven to be highly effective in the field of natural language processing (NLP), especially in the applications such as machine translation and text summarization.

The design concept according to the present application is a graph-neural-network meteorological large model that introduces a multilayer dynamic graph and an attention mechanism. The connection mode of the graph structure is adjusted according to the time-sequence dynamics and the variation of meteorological conditions, and the attention mechanism can dynamically focus on the information on important neighbor nodes. In addition, the multilayer graph structure has a denser node distribution in the near-earth layers, thus the temporal and spatial variations of the new-energy meteorological variables is more accurately modelled and predicted, which in turn serves as the basis of the power prediction, and improves the accuracy of the power prediction.

On the basis of the above-described design concept, the technical solution according to the present embodiment includes:

1. Based on ERA5 data, datasets for training the new-energy meteorological large model are constructed:

1.1 An input dataset includes reanalysis data which refers to the ERA5 data with a standard longitude-latitude grid resolution of $0.25° \times 0.25°$. ERA5 is a global-scale high-resolution atmospheric reanalysis dataset that is developed and maintained by European Centre for Medium-Range Weather Forecasts (ECMWF). An embodiment of the present invention utilizes the ERA5 data of regular 0.25° grid as input dataset.

Table 1: table of input variables

| Single level variables (15) | Atmospheric variables (5) | Pressure levels (37) |
|---|---|---|
| 2-meter temperature | Temperature | 1, 2, 3, 5, 7, 10, 20, 30, 50, 70, 100, 125, 150, 175, 200, 225, 250, 300, 350, 400, 450, 500, 550, 600, 650, 700, 750, 775, 800, 825, 850, 875, 900, 925, 950, 975, 1000 (hPa) |
| Mean sea-level pressure | Specific humidity | |
| 10 meter u wind component | U component of wind | |
| 10 meter v wind component | V component of wind | |
| 100 meter u wind component | Geopotential | |
| 100 meter v wind component | Vertical wind speed | |
| Total sky direct solar radiation at surface | | |
| Surface solar radiation downwards | | |
| Total_cloud_cover | | |
| Cloud base height | | |
| High cloud cover | | |
| Low cloud cover | | |
| Medium cloud cover | | |
| Total column cloud liquid water | | |
| Total column cloud ice water | | |

Table 1 contains examples of the meteorological variables included in the input dataset.

1.2 An output dataset are integrated and constructed from: wind-speed data and irradiance data that are interpolated from the ERA5 data to the locations of wind and solar power plants, measured wind-speed data and measured irradiance data that measured at the locations of wind and solar power plants.

The particular process is: using the ERA5 data with a longitude-latitude resolution being 0.25°×0.25° and calculating meteorological data of the wind speed and the irradiance by applying two-dimensional linear interpolation to the ERA5 data according to the longitude-latitude coordinates of the wind-power-generation plants and the photovoltaic plants, so as to obtain the wind-speed data and the irradiance data of the corresponding plant locations.

2. A graph-neural-network large model that has wind-solar-node attention and a dynamic graph structure is constructed, which includes three components of Encoder-Processor-Decoder.

2.1 The encoder is mainly responsible for embedding the input data of meteorological variables into the nodes and the edges of an initial dynamic graph. The input data of meteorological variables refer to the data corresponding to the variables in the reanalysis data. The encoding specifically includes the following steps:

2.1.1 Initializing the dynamic graph structure, the steps are as follows:

The dynamic graph structure may be deemed as a multilayer grid-graph structure encircling the exterior of the earth. Each layer represents a different pressure level of the ERA5 data. The ERA5 data generally comprises 37 pressure levels as listed in Table.1, which correspond to different atmospheric pressures. The grid points in each of the pressure levels represent the nodes. The number of the pressure level is represented by $l$, it is set that there are $L$ pressure levels in total, i.e., $L$ layers in total, the set of the nodes included in each layer is denoted as $V_l$, and the set of the edges is denoted as $E_l$. The set of nodes included in all layers is denoted as $V$, $V =$ $\bigcup_{l=1}^{L} V_l$, and the set $E$ of all of the edges is $E = \bigcup_{l=1}^{L} \left( E_l \cup E_{l,l+1} \right)$, wherein $E_{l,l+1}$ represents the set of the edges between each of the layers $l$ and the next layer $l+1$. That is because the nodes in each layer are not only connected in this layer, but also connected to the nodes of the upper layer and the lower layer (i.e., previous and next layers). Moreover, each of the connecting lines (edges) has the graph-neural-network parameters, and these parameters simulate the interaction of the meteorological variables between the layers, and are dynamically updated.

In the dynamic graph structure, in a layer closer to the ground, i.e., a layer represents a higher pressure level, the nodes have a higher density, and the nodes and edges have higher quantities. In the present embodiment, the ground pressure level, i.e., the layer with the atmospheric pressure of the ground is configured as the densest layer, and is set as a longitude-latitude grid of a resolution of 0.1 degrees. The quantity N of the nodes (grid points) of the densest layer is $N = n_{lat} \cdot n_{lon} \cdot (1/r)$, wherein $n_{lon}$ is the quantity of the longitude lines of the densest layer, and may be 360 in the present embodiment, $n_{lat}$ is the quantity of the latitude lines of the densest layer, and may be 180 in the present embodiment, and the resolution r=0.1.

(1) The nodes: the quantity $N_l$ of the nodes in each layer is in direct proportion to the atmospheric pressure $P_l$ of that layer, and the quantity of the nodes of each of the layers may be:

$$N_l = \frac{P_l}{\sum_{l=1}^{L} P_l} \cdot N.$$

(2) The edges: the nodes in the same layer are connected to all of the neighboring nodes in their periphery, to form an edge set $E_l$, wherein the quantity of the edges of the edge set $E_l$ is $M_l$.
(3) The quantity of the edges between each of the layers and its neighboring layer is in direct proportion to the sum of the atmospheric pressures of the two layers:

$$M_{l,l+1} = a \cdot (P_l + P_{l+1}) \cdot \frac{N_l \cdot N_{l+1}}{\sum_{l=1}^{L} N_l};$$

$M_{l,l+1}$ represents the quantity of the edges between each of the layers and the next layer, $P_{l+1}$ represents the atmospheric pressure of the next layer, $N_{l+1}$ represents the quantity of the nodes in the next layer, and a is a parameter.
In the dynamic graph structure, the layers are interconnected, the dynamic graph structure is used as the initial structure of the dynamic graph neural network, and the graph-neural-network parameters are used to simulate the interaction between the meteorological variables.
2.1.2. Embedding data (Embedding): firstly, performing standardization to the input data, the input data refers to the input data of the meteorological variables included in the input dataset (e.g., normalizing to zero mean and the unit variance). This facilitates the model to process the data of different dimensions. Subsequently, mapping the input data to each node and edge of the dynamic graph structure.
Regarding each of the nodes:

$$h = f(x, \theta);$$

wherein h is the feature vector of the node, x is the data of the meteorological variables input/mapped into the node, f is a learnable multilayer perceptron (MLP) network, and $\theta$ is a network parameter.
Regarding the edges:

$$e_{uv} = f(h_u, h_v, \varepsilon);$$

$e_{uv}$ represents the feature vector of the edge between the node u and the node v, f is a learnable MLP network, and $\varepsilon$ is a network parameter. This formula represents mapping, by MLP, the feature vectors $h_u$ and $h_v$ of two connected nodes (the node u and the node v) to the edge between them to obtain a high-dimension meteorological feature vector $e_{uv}$.
With the above embedding operation, each of the nodes and each of the edges of the dynamic graph structure carry high-dimension meteorological features.
2.2 The processor is mainly configured for, updating the dynamic graph structure and further processing the features of the nodes and the edges in the graph structure.
2.2.1. Employing a dynamic graph-neural-network structure. With the training and the iteration of the graph neural network, the model may dynamically add or delete the edges, so as to reflect the interaction between the features in the current state of the model. In dynamic graph neural networks, the updating of the edges usually relies on the features of the nodes in the graph, and these features change with the training and the iteration to reflect the newest information. The updating of the graph may be defined by a conditional intensity function, wherein the function determines, based on the states of the nodes, whether to add or delete an edge between two nodes.
The conditional intensity function $\lambda_{u,v}(t)$ measures the possibility of forming at a, an edge between the node u and the node v at a time point t. This intensity may be calculated based on the feature embeddings of the nodes and the historical interaction between them:

$$\lambda_{u,v}(t) = F(z_u(t), z_v(t), h_{uv});$$

wherein:

$z_u(t)$ and $z_v(t)$ are the feature embeddings of the nodes u and v at the time t, $h_{uv}$ is the historical information of interaction between the nodes u and v, and F is a function obtained by learning, which is used to evaluate the intensity of the generation of the edges.

The updating of the edges in the dynamic graph generally follows the rule that, if $\lambda_{u,v}(t)$ exceeds a certain threshold, then one edge is formed between the nodes u and v, and if the interaction between the nodes decreases or $\lambda_{u,v}(t)$ is smaller than a certain threshold, an edge is deleted.

2.2.2. Adding the attention mechanism: firstly, applying linear transformation W to the feature vector h of each node, to obtain the features after the linear transformation $W\vec{h}$.

Subsequently, based on the attention mechanism $\alpha$, calculating an attention coefficient E between the nodes, this coefficient characterizes the importance of one node to another node. The formula is:

$$E_{uv} = \alpha(W\vec{h_u}, W\vec{h_v});$$

wherein $E_{uv}$ represents the attention coefficient between the node u and the node v; $W\vec{h_u}$ represents the feature obtained after applying the linear transformation W to the feature vector $h_u$ of the node u; and $W\vec{h_v}$ represents the feature obtained after applying the linear transformation W to the feature vector $h_v$ of the node v.

Subsequently, the attention coefficients of each node with respect to all the other nodes are normalized by the Softmax function, to obtain normalized attention coefficients. It should be ensured that the sum of the normalized attention coefficients of each node with respect to all the other nodes is 1.

$$E'_{uv} = softmax(E_{uv}) = \frac{exp(E_{uv})}{\sum_{v \in V} exp(E_{uv})};$$

wherein $E'_{uv}$ represents the normalized attention coefficient between the node u and the node v.

Finally, using the normalized attention coefficients and the features after the linear transformation, new feature vectors of the nodes are calculated, and feature aggregation is performed.

$$\vec{h}^{'} = \sigma(\sum_{v \in V} E'_{uv} W \vec{h_v});$$

wherein $\sigma$ is a nonlinear activation function. This step allows the model to focus on the most important information, thereby the accuracy of the prediction is increased.

2.3 The decoder is mainly responsible for decoding the node features and the edge features that have been processed by the processor into the output meteorological data.

The decoder is configured to use MLP for performing inverse mapping to the node information and the edge information included in the dynamic graph structure, wherein the input of the MLP is the high-dimension meteorological-feature information carried by the nodes and the edges after being processed by the processor, and the output of the MLP is the meteorological data. This layer generates one predicted value for each of the nodes, wherein the predicted value is the meteorological-prediction data for the next moment. In the present embodiment, the meteorological-prediction data mainly includes the wind-speed data and the irradiance data.

3. Training:

The input dataset and the output dataset constructed in the step 1 are applied to the graph-neural-network large model in the step 2, and by parallel training by using a plurality of GPUs, a pre-trained meteorological large model is obtained. The output variables of this model are the same as the input variables (for example, as in Table 1), and can realize prediction of different time steps of 1h, 3h and 6h, and the overall effective prediction duration is 15 days, wherein the surface-layer variables, i.e., the output of the ground pressure level layer, are the predicting meteorological variables that have been optimized by the model with respect to new-energy applications.

4. A meteorology-power post-correction model based on integrated learning is constructed. Firstly, data processing is performed to the historical meteorological data and the actually-measured-power data. Subsequently, training is performed based on the XGBoost model with the meteorological data as the input and the actually measured power as the output, and the relation between the historical new-energy wind-solar meteorological data and the actually measured powers is established, to obtain the machine-learning model that converts the meteorology into the power prediction.

5. An initial real-time-meteorology field is input, the pre-trained meteorological large model obtains the new-energy meteorological predication output at the locations of the wind and solar plants, and subsequently the meteorology output by the large model is converted into the power by using the meteorology-power post-correction model of step 4, to obtain the power prediction.

The method for constructing the new-energy meteorological large model and the method for predicting a new-energy power according to present invention integrate the leading-edge techniques such as big-data processing, deep learning and machine learning. The methods, based on the technique of new-energy meteorological large models, optimize the prediction on the new-energy-related variables from the predicting source of the global meteorological source, break through the dependencies of the existing power prediction on the traditional meteorological numerical weather prediction, thereby improving the efficiency and the accuracy of the meteorological models in predicting the important new-energy meteorological variables of the wind speed and the irradiance. As compared with the traditional large models such as Graphcast, this technique of the present invention introduces the dynamic graph and the attention mechanism, which fits the variation of complex meteorological modalities more closely, and is effectively optimizes with respect to the hub-height wind and the irradiance. With the denser nodes arrangement in the near-earth dynamic graph structure, the model has a better ability in predicting the near-earth variables, which increases the accuracy of prediction on new-energy meteorological variables. The root mean square error (rmse) of the wind speed prediction is reduced by approximately 0.3m/s, the accuracy of the prediction on the irradiance is increased by 3%, and the effective prediction duration is prolonged to 15 days, which are of great significance for the development of the field of new energy and the high-efficiency management on wind-power-generation resource.

The above description is merely preferable embodiments of the present application, and is not indented to limit the present application. Any modifications, equivalent substitutions and improvements that are made within the spirit and the principle of the present application should fall within the protection scope of the present application.

## Claims

1. A method for constructing a new-energy meteorological large model for new energy-related meteorology prediction, **characterized in that** the method comprises:

   based on ERA5 data, constructing (S1) datasets for training the new-energy meteorological large model, wherein an input dataset comprises reanalysis data, the reanalysis data refers to the ERA5 data with a longitude-latitude grid resolution of 0.25°×0.25°, an output dataset comprises wind-speed data and irradiance data that are interpolated from the ERA5 data to locations of wind and solar power plants, measured wind-speed data and measured irradiance data;

   constructing (S2) a graph-neural-network large model that has a wind-solar-node attention mechanism and a dynamic graph structure, wherein the dynamic graph structure is configured to be a multilayer grid-graph structure encircling an exterior of the earth, wherein each layer represents a different pressure level, and each grid point in each of the layers represents a node of the graph-neural-network; a layer closer to the earth has a higher node density, and a higher amount of nodes and edges

   wherein the graph-neural-network large model comprises an encoder, a processor and a decoder:

      the encoder is configured for encoding and embedding input data of meteorological variables into nodes and edges of an initial dynamic graph structure;
      the processor is configured for updating the dynamic graph structure and adding the wind-solar-node attention mechanism to process features of the nodes and the edges in the dynamic graph structure; and
      the decoder is configured for decoding node features and edge features processed by the processor to be output meteorological prediction data;

   applying (S3) the input dataset and the output dataset into the graph-neural-network large model, and performing training on the graph-neural-network large model to obtain the new-energy meteorological large model.

2. The method for constructing the new-energy meteorological large model according to claim 1, wherein the encoder is specifically configured for:

initializing (S211) the dynamic graph structure, so that a quantity of the nodes in each of the layers is in direct proportion to an atmospheric pressure of that layer, neighboring layers are interconnected via the edges, and a quantity of the edges interconnecting two neighboring layers is in direct proportion to a sum of the atmospheric pressures of the two neighboring layers; and

performing standardization (S212) to each input data in the input dataset, and mapping the input data to the nodes and the edges of the dynamic graph structure, so that each of the nodes and each of the edges of the dynamic graph structure carry high-dimension meteorological-feature information.

3. The method for constructing the new-energy meteorological large model according to claim 1, wherein the processor is specifically configured for:

based on the dynamic graph structure, calculating (S221) a conditional intensity function between the nodes, and determining whether to add the edges or delete the edges between the nodes according to the conditional intensity function; and

applying (S222) a linear transformation to feature vectors of each of the nodes, and based on the attention mechanism, calculating attention coefficients between the nodes, normalizing all attention coefficients of each of the nodes, and, calculating new feature vectors of the nodes using the normalized attention coefficients and the feature vectors after the linear transformation.

4. The method for constructing the new-energy meteorological large model according to claim 1, wherein the decoder is specifically configured for: performing inverse mapping to node information and edge information in the dynamic graph structure, and generating one predicted value for each of the nodes, wherein the predicted value is a meteorological-prediction data of a next moment.

5. An apparatus for constructing a new-energy meteorological large model, **characterized in that** the apparatus comprises:

a dataset module configured to based on ERA5 data, construct datasets for training the new-energy meteorological large model, wherein an input dataset comprises reanalysis data, the reanalysis data refers to the ERA5 data with a longitude-latitude resolution of $0.25° \times 0.25°$,

an output dataset comprises wind-speed data and irradiance data that are interpolated from the ERA5 data to locations of wind and solar power plants, measured wind-speed data and measured irradiance data;

a model module configured to construct a graph-neural-network large model that has a wind-solar-node attention mechanism and a dynamic graph structure, wherein the dynamic graph structure is designed to be a multilayer grid-graph structure encircling an exterior of the earth, wherein each layer represents a different pressure level, and each grid point in each of the layers represents a node of the graph-neural-network; in a layer closer to earth, the nodes have a higher density, and the nodes and edges have higher quantities; and

wherein the graph-neural-network large model comprises an encoder, a processor and a decoder:

the encoder is configured to encode and embed input data of meteorological variables into nodes and edges of an initial dynamic graph structure;

the processor is configured to update the dynamic graph structure and to add the wind-solar-node attention mechanism to process features of the nodes and the edges in the dynamic graph structure; and

the decoder is configured to decode node features and edge features processed by the processor to be output meteorological-prediction data;

the apparatus further comprises a training module configured to apply the input dataset and the output dataset constructed by the dataset module into the graph-neural-network large model constructed by the model module, and to perform training on the graph-neural-network large model to obtain the new-energy meteorological large model.

6. The apparatus for constructing the new-energy meteorological large model according to claim 5, wherein the encoder comprises:

an initializing unit configured to initialize the dynamic graph structure, so that a quantity of the nodes in each of the layers is in direct proportion to an atmospheric pressure of that layer, neighboring layers are interconnected via the edges, and a quantity of the edges interconnecting two neighboring layers is in direct proportion to a sum of the atmospheric pressures of the two neighboring layers; and

a data embedding unit configured to perform standardization to each input data in the input dataset, and mapping the input data to the nodes and the edges of the dynamic graph structure, so that each of the nodes and each of the edges of the dynamic graph structure carry high-dimension meteorological-feature information.

7.  The apparatus for constructing the new-energy meteorological large model according to claim 5, wherein the processor comprises:

    an updating unit configured to, based on the dynamic graph structure, calculate a conditional intensity function between the nodes, and determining whether to add the edges or delete the edges between the nodes according to the conditional intensity function; and
    an attention unit configured to apply a linear transformation to feature vectors of each of the nodes, , calculate attention coefficients between the nodes based on the attention mechanism, normalize all attention coefficients of each of the nodes, and , calculate new feature vectors of the nodes using the normalized attention coefficients and the feature vectors after the linear transformation.

8.  The apparatus for constructing the new-energy meteorological large model according to claim 5, wherein the decoder is specifically configured to:
    perform inverse mapping to node information and edge information in the dynamic graph structure, and generate one predicted value for each of the nodes, wherein the predicted value is a meteorological-prediction data of a next moment.

9.  A method for predicting a new-energy power, **characterized in that**, the method comprises:

    obtaining a meteorology-power post-correction model;
    obtaining new-energy meteorological-prediction data at locations of wind and solar power plants using a new-energy meteorological large model constructed by the method for constructing the new-energy meteorological large model according to any one of claims 1-4, and
    inputting the new-energy meteorological-prediction data at the locations of wind and solar power plants into the meteorology-power post-correction model to obtain a predicted power.

10. A device for predicting a new-energy power, **characterized in that** the device is configured to:

    obtain a meteorology-power post-correction model by training based on historical new-energy wind-solar meteorological-element data and an actually measured power;
    obtain new-energy meteorological-prediction data at locations of wind and solar power plants using the new-energy meteorological large model constructed by the apparatus for constructing the new-energy meteorological large model according to any one of claims 5-8, and
    input the new-energy meteorological-prediction data at the locations of wind and solar power plants into the meteorology-power post-correction model to obtain a predicted power.

Based on ERA5 data, constructing datasets for training the new-energy meteorological large model $\quad$ 1

In combination with a multilayer dynamic graph structure and an attention mechanism, constructing the new-energy meteorological large model based on a graph neural network, wherein the major structure is Encoder-Processor-Decoder $\quad$ 2

Inputting the training dataset into the graph-neural-network large model, and performing parallel training on a plurality of GPUs, to obtain a pre-trained meteorological large model $\quad$ 3

Modeling by machine learning, and establishing the relation between the historical new-energy wind-solar meteorological elements and the actually measured powers, to obtain a meteorology-power post-correction model $\quad$ 4

Inputting an initial real-time-meteorology field, driving the pre-trained meteorological large model to obtain the station new-energy meteorology, and subsequently converting the meteorology outputted by the large model into the power by using the meteorology-power post-correction model, to obtain the power prediction $\quad$ 5

FIG. 1

Europäisches
Patentamt

European
Patent Office

Office européen
des brevets

# EUROPEAN SEARCH REPORT

**Application Number**

EP 24 20 1320

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | GAO ZIHENG ET AL: "Dynamic adaptive spatio-temporal graph neural network for multi-node offshore wind speed forecasting", APPLIED SOFT COMPUTING, ELSEVIER, AMSTERDAM, NL, vol. 141, 17 April 2023 (2023-04-17), XP087313411, ISSN: 1568-4946, DOI: 10.1016/J.ASOC.2023.110294 [retrieved on 2023-04-17] * abstract; figure 1 * * 1.1 Background, 1.4 Major contributions and organization 3. Problem formulation 4.2 Dynamic adaptive graph generation module 5.1 Dataset 5.4 Experimental settings 5.5.1 Prediction result analysis * ----- | 1-10 | INV. G01W1/10 G06N3/042 |
| Y | REMI LAM ET AL: "GraphCast: Learning skillful medium-range global weather forecasting", ARXIV.ORG, CORNELL UNIVERSITY LIBRARY, 201 OLIN LIBRARY CORNELL UNIVERSITY ITHACA, NY 14853, 24 December 2022 (2022-12-24), XP091402367, [retrieved on 2025-02-24] * the whole document * ----- -/-- | 1-10 | TECHNICAL FIELDS SEARCHED (IPC) G01W G06N |

The present search report has been drawn up for all claims

| Place of search | Date of completion of the search | Examiner |
|---|---|---|
| The Hague | 25 February 2025 | Phleps, Stefanie |

EPO FORM 1503 03.82 (P04C01)

Europäisches
Patentamt

European
Patent Office

Office européen
des brevets

**EUROPEAN SEARCH REPORT**

Application Number

EP 24 20 1320

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JIAO XUAN ET AL: "A Graph Neural Network Based Deep Learning Predictor for Spatio-Temporal Group Solar Irradiance Forecasting", IEEE TRANSACTIONS ON INDUSTRIAL INFORMATICS, [Online] vol. 18, no. 9, 1 September 2022 (2022-09-01), pages 6142-6149, XP093253661, US ISSN: 1551-3203, DOI: 10.1109/TII.2021.3133289 Retrieved from the Internet: URL:https://ieeexplore.ieee.org/stampPDF/g etPDF.jsp?tp=&arnumber=9653868&ref=aHR0cHM 6Ly9pZWVleHBsb3JlLmllZWUub3JnL2RvY3VtZW50L zk2NTM4Njg=> [retrieved on 2025-02-25] * the whole document * | 1-10 | |

TECHNICAL FIELDS
SEARCHED       (IPC)

The present search report has been drawn up for all claims

| Place of search | Date of completion of the search | Examiner |
|---|---|---|
| The Hague | 25 February 2025 | Phleps, Stefanie |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

..............................................................................................

& : member of the same patent family, corresponding document

EPO FORM 1503 03.82 (P04C01)